Europäisches Patentamt

European Patent Office

Office européen des brevets

(11) Publication number: **0 079 775**
**B1**

(12) EUROPEAN PATENT SPECIFICATION

(45) Date of publication of patent specification: **26.04.89**

(51) Int. Cl.⁴: **H 01 L 23/56,** H 01 L 23/52

(21) Application number: **82306038.9**

(22) Date of filing: **12.11.82**

(54) Protection against erroneous signal generation in semiconductor devices.

(30) Priority: **13.11.81 JP 182114/81**

(43) Date of publication of application:
**25.05.83 Bulletin 83/21**

(45) Publication of the grant of the patent:
**26.04.89 Bulletin 89/17**

(84) Designated Contracting States:
**DE FR GB**

(56) References cited:
**DE-A-2 522 984**
**FR-A-1 471 729**
**US-A-3 602 782**
**US-A-3 841 926**
**US-A-3 990 102**

(73) Proprietor: **FUJITSU LIMITED**
**1015, Kamikodanaka Nakahara-ku**
**Kawasaki-shi Kanagawa 211 (JP)**

(72) Inventor: **Nakano, Tomio**
**1-11-2-12-404, Shirahatadai Miyamae-ku**
**Kawasaki-shi Kanagawa 213 (JP)**
Inventor: **Nakano, Masao**
**Mezon Hisasue 506 473-4, Hisasue Takatsu-ku**
**Kawasaki-shi Kanagawa 213 (JP)**

(74) Representative: **Fane, Christopher Robin King**
**et al**
**HASELTINE LAKE & CO. Hazlitt House 28**
**Southampton Buildings Chancery Lane**
**London, WC2A 1AT (GB)**

EP 0 079 775 B1

Courier Press, Leamington Spa, England.

## Description

The present invention relates to protection against erroneous signal generation in semiconductor devices. An erroneous signal may be produced, for example, in a semiconductor memory device, as a result of a potential change on input signal lines being transferrd to bit lines of the device.

In, for example, a dynamic semiconductor memory device comprising a 64K bits random access memory (RAM), each sense amplifier should nowadays be able to detect the small potential difference of about 100 mV generated between pairs of bit lines. This has been necessitated by the decrease in individual cell capacities accompanying higher degrees of integration.

Such a high-sensitivity sense amplifier, however, may be rather susceptible to error operations due to noise. This is especially possible when the potentials of the input signals, for example address signals, are changed at the same time as sense amplifiers operate, or just before the operation of the sense amplifiers. This change can influence the potentials of the bit lines through parasitic electrostatic capacitances, as hereinafter described in more detail, causing error operations of the sense amplifiers.

It is desirable to provide protection against such potential fluctuation at signal lines of a semiconductor device, and in particular at bit lines of a semiconductor memory device, due to parasitic capacitances, and so to protect against error operations of a sense amplifier in such a dynamic semiconductor memory device.

It has been proposed in US—A—3 841 926 to provide in an integrated circuit device an intervening conductive layer embedded in an insulating layer as a field shield layer to prevent leakage currents and interference currents between source and drain regions formed as diffusion regions on the surface of a semiconductor substrate and a metallisation layer and electrode on the surface of the insulating layer.

In FR—A—1 471 729 conductive diffusion layers are provided in the surface of a dielectric substrate below metallic bonding pads of electrodes formed on an insulating layer above the substrate, to prevent capacitive effects between the bonding pads through the substrate.

According to the present invention a semiconductor memory device comprises a semiconductor substrate of a first conductivity type, a first and a second group of address signal lines arranged at first positions on said semiconductor substrate, and a pair of diffusion regions forming first and second bit lines, formed in said substrate at second positions lower than said first and second groups of address signal lines and respectively operationally associated therewith, each of said diffusion regions forming a parasitic capacitance with said semiconductor substrate and said semiconductor substrate forming a resistance; wherein an electrostaic shield layer is formed under at least one of said first and second groups of address signal lines, for shielding said semiconductor substrate to prevent transfer of a change in potential to at least one of said diffusion regions from said at least one of said first and second groups of address signal lines by capacitive coupling via said semiconductor substrate.

Reference will now be made, by way of example, to the accompanying drawings, wherein:

Figure 1 is a schematic plan view of a dynamic semiconductor memory device to which the present invention may be applied;

Figure 2 is a cross-sectional view, to an enlarged scale, taken along line II—II' of Figure 1;

Figure 3 is a cross-sectional view illustrating part of a dynamic semiconductor memory device according to a first embodiment of the present invention; and

Figure 4 is a cross-sectional view illustrating a part of a dynamic semiconductor memory device according to a second embodiment of the present invention.

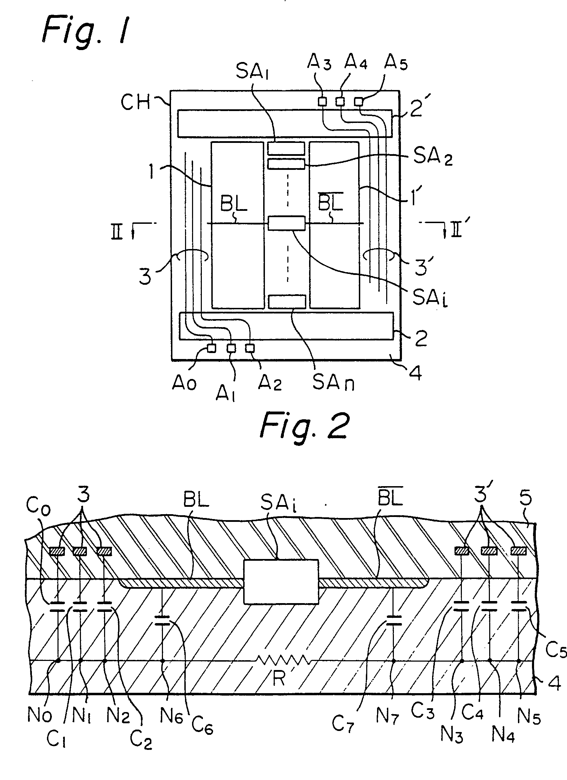

Figure 1 qhows a general structure of a dynamic semiconductor memory device to which the present invention may be applied. A dynamic semiconductor memory chip CH includes in its central portion a plurality of sense amplifiers $SA_1$, $SA_2$, ..., $Sa_i$, ..., and $SA_n$. To the right and left of each sense amplifier extend a pair of bit lines BL and $\overline{BL}$ respectively. For the purpose of simplicity, only one pair of bit lines is illustrated. The bit lines BL and $\overline{BL}$ are connected to memory cells (not shown) arranged in memory cell arrays 1 and 1'. Reference numerals 2 and 2' represent peripheral circuits of, for example, decoders or buffer amplifiers. Reference numerals 3 and 3' are input signal lines connected to input terminals $A_0$, $A_1$, $A_2$, $A_3$, $A_4$ and $A_5$. The input terminals $A_0$ through $A_5$ receive input signals of, for example, address input signals or data. All of the above elements and lines are formed on a semiconductor substrate 4.

The bit lines BL and $\overline{BL}$ are diffusion layers formed at the surface of the semiconductor substrate 4. Therefore an electrostatic capacitance is formed between each bit line BL or $\overline{BL}$ and the semiconductor substrate 4. When the bit lines BL and $\overline{BL}$ are formed by diffusion layers, the electrostatic capacitance is greater than that when the bit lines BL and $\overline{BL}$ are formed by polysilicon or aluminum.

The input signal lines 3 and 3' are wiring layers of, for example, aluminum formed on the substrate 4 through an insulating layer (not shown in Figure 1). Therefore, an electrostatic capacitance is also formed between each input signal line and the semiconductor substrate 4.

The above-mentioned capacitance may cause a problem, as hereinafter described with reference to Figure 2, showing an expanded cross-section taken along line II—II' of Figure 1. In Figure 2, the bit lines BL and $\overline{BL}$ are formed as diffusion layers at the surface of the semiconductor substrate 4. The input signal lines 3 and 3' extend in an insulating layer 5 formed on the semiconductor substrate 4. An equivalent circuit, showing the electrical relationship among the bit lines BL and $\overline{BL}$, the semiconductor substrate 4, and the input signal lines 3 and 3', is also illustrated in Fig. 2.

As mentioned before, between each input signal line 3 and the semiconductor substrate 4, there is an electrostatic capacitance $C_0$, $C_1$, or $C_2$. Also, an electrostatic capacitance $C_3$, $C_4$, or $C_5$ is formed between each input signal line 3' and the semiconductor substrate 4. Further, between the bit lines BL and $\overline{BL}$ and the semiconductor substrate 4, there are electrostatic capacitances $C_6$ and $C_7$, respectively. Since the semiconductor substrate 4 has a resistance, a resistance R is illustrated between the capacitances $C_6$ and $C_7$. $N_0$ through $N_7$ in the semiconductor substrate 4 are nodes connected to these capacitances $C_0$ through $C_7$, respectively.

Due to the presence of these capacitances, the potential of the semiconductor substrate is influenced by the potential of the input signal lines 3 and 3'. In other words, if the potentials of the input signal lines 3 and 3' are changed by changing the address signals or data applied to the input terminals $A_0$ through $A_5$, the potentials at the nodes $N_0$ through $N_5$ in the semiconductor substrate 4 are also changed. If the potentials of both groups of the input signal lines 3 and 3' are changed simultaneously in the same direction, i.e., from a high (H) level to a low (L) level or from a low (L) level to a high (H) level, and if the number of the input signal lines 3 is the same as the number of the input signal lines 3', no problem will occur.

When one group of the input signal lines 3 changes simultaneously from the L level to the H level and the other group of the input signal lines 3' changes simultaneously from the H level to the L level, however the worst case will occur. In this worst case, the potentials at the anodes $N_0$, $N_1$, and $N_2$ are simultaneously boosted, and the potentials at the anodes $N_3$, $N_4$, and $N_5$ are simultaneously lowered. Since the node $N_6$ is relatively close to the nodes $N_0$ through $N_2$, the potential at the anode $N_6$ is also boosted. Also, since the node $N_7$ is relatively close to the nodes $N_3$ through $N_5$, the potential at the node $N_7$ is also lowered. Due to the presence of the capacitance $C_6$, the potential of the bit line BL is boosted. Also, due to the presence of the capacitance $C_7$, the potential of the bit line $\overline{BL}$ is lowered. Since the nodes $N_6$ and $N_7$ are separated by the resistance R, the potentials of the nodes $N_6$ and $N_7$ can not be equilibrated for a definite period due to the presence of the resistance R. Thus, the maximum potential difference is produced between the bit lines BL and $\overline{BL}$. Assume that the actual data stored in a memory cell is one for increasing the potential of the bit line $\overline{BL}$ over the potential of the bit line BL. In this condition, if a reading operation is effected with respect to the above memory cell simultaneously with the change of the potentials, due to the capacitances, of the bit lines BL and $\overline{BL}$, the capacitances $C_0$ through $C_7$ may conversely

make the potential of the bit line BL higher than the potential of the bit line $\overline{BL}$, causing the sense amplifier $SA_i$ to detect erroneous data.

A similar discussion applies to the case when the input signal lines 3 simultaneously change from the H level to the L level and the input signal lines 3' simultaneously change from the L level to the H level.

The signals to be applied to the input signal lines can take any value. That is, it is not predetermined what type of signals they are, i.e., what combination of the H levels and L levels they are. Depending on the combination of the input signals, it is possible that the potential difference between the bit lines BL and $\overline{BL}$ due to the capacitances $C_0$ through $C_7$ will become sufficiently large to cause an error reading of the sense amplifier $SA_i$.

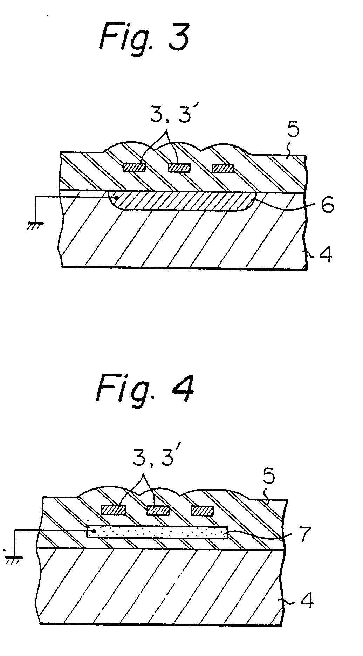

Embodiments of the present invention will now be described with reference to Figs. 3 and 4.

Figure 3 is a cross-section of a part of a dynamic semiconductor memory device according to a first embodiment of the invention. In the figure, the input signal lines 3 or 3', the semiconductor substrate 4, and the insulating layer 5 are the same as those in Fig. 2. The difference between Figs. 2 and 3 is that, in Fig. 3, a diffusion layer 6 of a conductivity type opposite to that of the semiconductor substrate 4 is formed at the surface of the semiconductor substrate 4 and under the input signal lines 3 or 3'. The diffusion layer 6 is connected to the ground. Alternatively, the diffusion layer 6 may be connected to a power supply (not shown). The diffusion layer 6 may be formed under one group of the input signal lines 3 and 3' or under both groups of the input signal lines 3 and 3'.

Figure 4 illustrates another embodiment of the present invention. In Fig. 4, instead of the diffusion layer 6 in Fig. 3, a wiring layer 7, made of a good conductor such as polysilicon, aluminum, molybdenum (Mo), or molybdenum-silicide ($MoSi_2$) is formed in the insulating layer 5 and under the input signal lines 3 or 3'. The wiring layer 7 is also connected to the ground or to a power supply. The wiring layer 7 may also be formed under one group of the input signal lines 3 or 3', or under both groups of the input signal lines 3 and 3'.

The diffusion layer 6 in Fig. 3 and the wiring layer 7 in Fig. 4 act as electrostatic shield layers, respectively, of the input signal lines 3 and/or 3' for the semiconductor substrate 4. Accordingly, changes of the potentials at the input signal lines 3 and 3' by external input signals have no effect on the potential of the semiconductor substrate 4. Therefore, little or no potential difference is produced between the bit lines BL and $\overline{BL}$ in response to the potential change of the input signal lines 3 and 3'. Thus, error reading by the sense amplifier in the dynamic semiconductor memory device can be protected against.

The present invention is not restricted to the above-described dynamic semiconductor memory device. Many other modifications and changes are possible without departing from the spirit of the present invention. For example, a shielding layer such as layers 6 and 7 is also effective in other static semiconductor memory devices, code converters (CODEC), and many other semiconductor devices having the other features of claim 1.

**Claims**

1. A semiconductor memory device comprises a semiconductor substrate (4) of a first conductivity type, a first and a second group (3, 3') of address signal lines arranged at first positions on said semiconductor substrate, and a pair of diffusion regions (BL, $\overline{BL}$) forming first and second bit lines, formed in said substrate at second positions lower than said first and second groups of address signal lines and respectively operationally associated therewith, each of said diffusion regions forming a parasitic capacitance with said semiconductor substrate and said semiconductor substrate forming a resistance; wherein an electrostatic shield layer (6, 7) is formed under at least one of said first and second groups of address signal lines, for shielding said semiconductor substrate to prevent transfer of a change in potential to at least one of said diffusion regions from said at least one of said first and second groups of address signal lines by capacitative coupling via said semiconductor substrate.

2. A device as claimed in claim 1, wherein the said electrostatic shield layer is connected to a constant-voltage reference terminal of the device.

3. A semiconductor device as claimed in claim 1 or claim 2, wherein said electrostatic shield layer is a diffusion layer of opposite conductivity type to the said semiconductor substrate, which diffusion layer is formed at the surface of said semiconductor substrate.

4. A semiconductor device as claimed in claim 1 or claim 2, wherein said electrostatic shield layer is a wiring layer formed on said semiconductor substrate, said wiring layer being formed of material of good electrical conductivity.

**Patentansprüche**

1. Halbleiterspeichervorrichtung mit einem Halbleitersubstrat (4) von einem ersten Leitfähigkeitstyp, einer ersten und einer zweiten Gruppe (3, 3') von Adreßsignalleitungen, die an ersten Positionen des genannten Halbleitersubstrates angeordnet sind, und einem Paar von Diffusionsbereichen (BL, $\overline{BL}$), die erste une zweite Bitleitungen bilden, die in dem genannten Substrat an zweiten Positionen tiefer als die genannten ersten und zweiten Gruppen von Adreßsignalleitungen gebildet sind und diesen jeweils betrieblich zugeordnet sind, wobei jeder der Diffusionsbereiche eine parasitäre Kapazität mit dem Halbleitersubstrat bildet und das genannte Halbleitersubstrat einen Widerstand bildet; bei der eine elektrostatische Abschirmschicht (6, 7) unter wenigstens einer der genannten ersten und zweiten Gruppen von Adreßsignalleitungen gebildet ist, um das genannte Halbleitersubstrat abzuschirmen, um einen Transfer einer Änderung des Potentials zu wenigstens einem der genannten Diffusionsbereiche von der genannten wenigsten einen der genannten ersten und zweiten Gruppen von Adreßsignalleitungen durch kapazitive Kopplung über das genannte Halbleitersubstrat zu verhindern.

2. Vorrichtung nach Anspruch 1, bei der die genannte elektrostatische Abschirmschicht mit einem Konstantspannungs-Referanschluß der Vorrichtung verbunden ist.

3. Vorrichtung nach Anspruch 1 oder 2, bei der die genannte elektrostatische Abschirmschicht eine Diffusinsschicht von entgegengesetztem Leitfähigkeitstyp zu dem Halbleitersubstrat ist, welche Diffusionsschicht an der Oberfläche des genannten Halbleitersubstrates gebildet ist.

4. Halbleitervorrichtung nach Anspruch 1 oder Anspruch 2, bei der die genannte elektrostatische Schirmschicht eine Verdrahtungsschicht ist, die auf dem genannten Substrat gebildet ist, welche Verdrahtungsschicht aus einem Material von guter elektrischer Leitfähigkeit gebildet ist.

**Revendications**

1. Dispositif de mémoire à semiconducteurs comprenant un substrat semiconducteur (4) d'un premier type de conductivité, un premier et un deuxième groupe (3, 3') de lignes de signal d'adresse disposés en des premières positions sur ledit substrat semiconducteur, et une paire de régions de diffusion (BL, $\overline{BL}$) formant des première et deuxième lignes de bit, qui sont formées dans ledit substrat en des deuxièmes positions plus bas que lesdits premier et deuxième groupes de lignes de signal d'adresse et sont respectivement fonctionnellement associées avec ceux-ci, chacune desdites régions de diffusion formant une capacité parasite avec ledit substrat semiconducteur, et ledit substrat semiconducteur formant une résistance; où une couche d'écran électrostatique (6, 7) est formée sous au moins un groupe desdits premier et deuxième groupes de lignes de signal d'adresse pour réaliser un effet d'écran vis-à-vis dudit substrat semiconducteur afin d'empêcher le transfert d'une variation de potentiel à au moins une desdites régions de diffusion en provenance de ce dit groupe ou de ces dits groupes de lignes de signal d'adresse par couplage capacitif via ledit substrat semiconducteur.

2. Dispositif à semiconducteurs selon la revendication 1, où ladite couche d'écran électrostatique est connectée à une borne de référence à potentiel constant du dispositif.

3. Dispositif à semiconducteurs selon la revendication 1 ou 2, où ladite couche d'écran électrostatique est une couche de diffusion ayant un type de conductivité opposé à celui dudit substrat semiconducteur, laquelle couche de diffusion est formée à la surface dudit substrat semiconducteur.

4. Dispositif à semiconducteurs selon la revendication 1 ou 2, où ladite couche d'écran électrostatique est une couche de câblage formée sur ledit substrat semiconducteur, ladite couche de câblage étant formée d'un matériau ayant une bonne conductivité électrique.

*Fig. I*

*Fig. 2*

EP 0 079 775 B1

# Fig. 3

# Fig. 4